# FASCICULE DE BREVET EUROPEEN

(11) **EP 0 629 036 B1**
(45) Date de publication et mention de la délivrance du brevet: **04.03.1998**
(21) Numéro de dépôt: 94401283.0
(22) Date de dépôt: 08.06.1994
(51) Int. Cl.: H02M 3/158, H02M 7/217

(54) **Dispositif pour la fourniture d'une tension à un circuit électronique, en particulier à un circuit électronique associé à un capteur d'intensité placé sur une ligne électrique**
Anordnung zur Zuführung einer Spannung an eine elektronische Schaltung, besonders an eine elektronische Schaltung eines Stromsensors der auf einer elektrischen Leitung geschaltet ist
Device for supplying a voltage to an electronic circuit, in particular to an electronic circuit associated to a current sensor placed on an electric line

(30) Priorité: 10.06.1993 FR 9306992
(43) Date de publication de la demande: 14.12.1994
(73) Titulaire: GEC ALSTHOM T ET D SA, 75016 Paris (FR)
(72) Inventeur: Moncorge, Jean-Paul, F-69120 Vaulx en Velin (FR)
(74) Mandataire: Fournier, Michel

(56) Documents cités:
- EP-A- 0 371 555
- DE-A- 3 545 323
- INTERNATIONAL SYMPOSIUM ON INTELLIGENT INSTRUMENTATION FOR REMOTE AND ON-SITE MEASUREMENTS, 12 Mai 1993, BRUSSELS pages 121 - 126 HAWKINS 'A fibre-optic based resistance and AC conductivity measuring system for use with remote transducers'

## Description

La présente invention concerne la fourniture d'une tension à un circuit électronique et elle concerne notamment l'alimentation en énergie électrique du circuit électronique associé à un capteur d'intensité destiné à la mesure de l'intensité du courant électrique circulant dans une ligne à haute tension.

Un capteur d'intensité est constitué le plus souvent d'un shunt ou d'un tore ou d'une bobine de Rogowski; le capteur de courant est associé à un circuit électronique élaborant, à partir de l'information analogique fournie par le capteur, un signal, de préférence numérique, duquel on peut déduire la valeur de l'intensité du courant; ce signal est appliqué à une photodiode, ce qui permet d'acheminer l'information au sol au moyen d'une fibre optique. Le capteur et le circuit électronique associé sont au potentiel de la haute tension; la fibre optique est capable d'assurer l'isolement entre la haute tension et le sol.

Il se pose la question de l'alimentation du circuit électronique précité; il n'est pas question de transmettre l'énergie nécessaire depuis le sol par un transformateur conventionnel, en raison du fort isolement nécessaire qui ruinerait l'avantage du dispositif de mesure envisagé.

Il est donc nécessaire d'alimenter l'appareil à partir du courant de ligne, par exemple au moyen d'un tore doté d'un noyau magnétique dont le bobinage secondaire fournit le courant nécessaire à l'alimentation.

Cette disposition nécessite la solution de plusieurs problèmes techniques et c'est le but de la présente invention de fournir ces solutions.

Un premier problème se pose à l'apparition du courant, notamment en présence de composante apériodique du courant: il faut en effet plusieurs millisecondes pour obtenir un régime permanent permettant d'assurer l'alimentation. Le problème à résoudre est de fournir l'alimentation pendant ces quelques millisecondes précédant le régime permanent.

Une seconde difficulté intervient lorsque de fortes surcharges apparaissent, par exemple dues à des courants de court-circuit lors d'un défaut sur la ligne: l'alimentation doit pouvoir supporter ces surcharges passagères.

L'invention a pour objet un dispositif pour la fourniture d'une tension d'alimentation à un circuit électronique, en particulier à un circuit électronique associé à un capteur de courant pour la mesure du courant électrique d'une ligne à haute tension, ledit dispositif comprenant un transformateur de courant ayant un circuit primaire et un circuit secondaire, un pont redresseur aux bornes du circuit secondaire, et aux bornes de sortie du pont redresseur, un premier condensateur en parallèle avec une première résistance aux bornes de laquelle est prélevée ladite tension d'alimentation, un premier interrupteur étant disposé entre les bornes de sortie du pont redresseur, caractérisé en ce qu'il comprend, entre les bornes de sortie du pont redresseur, une branche comprenant en série un second condensateur, un second interrupteur et une seconde résistance, le premier interrupteur étant commandé par un premier détecteur à seuil aux bornes du second condensateur, le second interrupteur étant commandé par un second détecteur à seuil aux bornes du premier condensateur, les premier et second détecteurs de seuil provoquant la fermeture respective des premier et second interrupteurs lorsque des premier et second seuils prédéterminés sont respectivement atteints.

Le transformateur de courant comprend deux enroulements secondaires ayant des nombres respectifs de spires différents et reliés en serie au pont redresseur à travers un troisième interrupteur commandé.

Le troisième interrupteur est commandé par un troisième détecteur recevant les courants traversés par les enroulements secondaires.

En variante, le troisième interrupteur est commandé par ledit premier détecteur à seuil.

Le dispositif comprend, aux bornes de sortie du pont redresseur, une branche comprenant un troisième condensateur en série avec un quatrième interrupteur, ledit condensateur étant relié à une ligne d'alimentation recevant l'énergie électrique fournie à la sortie d'un convertisseur opto-électronique recevant en entrée de l'énergie lumineuse acheminée depuis le sol par une fibre optique, ledit quatrième interrupteur étant commandé par ledit troisième détecteur.

L'énergie lumineuse dans la fibre optique est envoyée sous forme d'impulsions utilisées en outre pour élaborer des ordres de synchronisation adressés audit circuit électronique.

L'invention sera bien comprise à la lumière de la description donnée ci-après de divers modes de réalisation de l'invention, en référence au dessin annexé dans lequel:
- la figure 1 est un schéma d'un dispositif de mesure de courant d'une ligne et du dispositif d'alimentation de son circuit électronique, selon l'état de la technique,
- la figure 2 est un diagramme illustrant le fonctionnement du dispositif d'alimentation de la figure 1, lorsque ce dernier comprend un condensateur de faible capacité,
- la figure 3 est un diagramme illustrant le fonctionnement du dispositif d'alimentation de la figure 1, lorsque ce dernier comprend un condensateur de forte capacité,
- la figure 4 est un schéma du dispositif d'alimentation du circuit électronique selon l'invention,
- la figure 5 est une schéma illustrant un mode de réalisation particulier du transformateur de courant équipant le dispositif d'alimentation de l'invention.

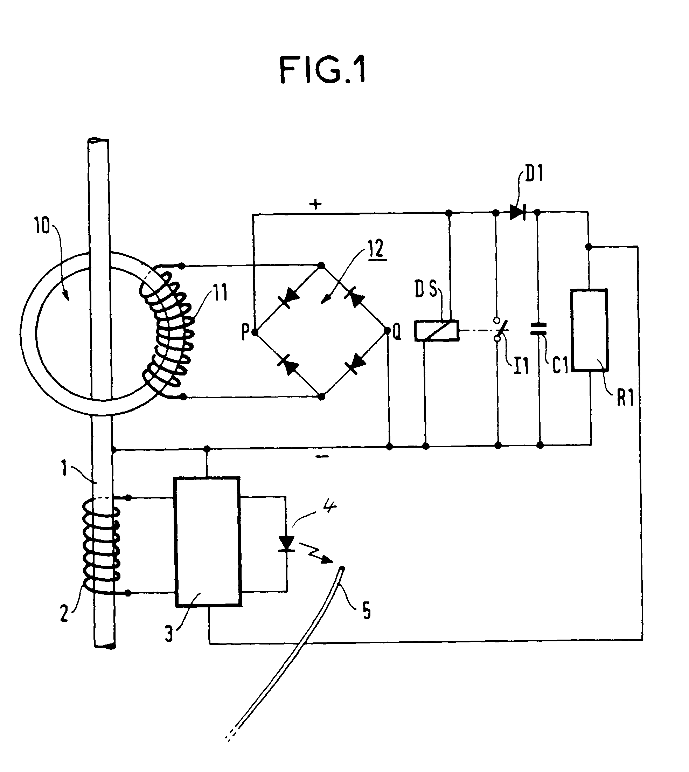

Dans le figure 1, la référence 1 désigne un fil de phase d'une ligne électrique dont on désire mesurer le courant. Dans ce qui suit, on ne décrira que les éléments relatifs à une phase, étant entendu que pour une ligne triphasée, les autres phases seront pourvues des mêmes dispositifs réalisés de manière identique.

Le dispositif de mesure du courant comprend un capteur 2, par exemple une bobine de Rogowski, associée à un circuit électronique 3 traitant le signal issu du capteur et fournissant en sortie un signal utile envoyé au sol grâce à une photodiode 4 et une fibre optique 5. Le dispositif de mesure du courant ne fait pas partie de l'invention et il ne sera pas décrit. Le lecteur pourra se reporter par exemple aux Techniques de l'Ingénieur, "Transformateur amagnétique de courant, Tore de Rogowski, D 4 724-8.

Selon une technique connue, le circuit électronique 3 est alimenté par la ligne elle-même, au moyen d'un dispositif comprenant un transformateur de courant comprenant un tore 10 à travers lequel passe le fil de phase 1, et dont le circuit secondaire 11 alimente un pont redresseur 12 qui charge un condensateur C1 à travers une diode D1. Lorsque la tension aux bornes du condensateur C1 atteint une première valeur donnée de seuil V1, un détecteur de seuil DS actionne un interrupteur électronique I1 qui vient court-circuiter le transformateur de courant 10. La diode D1 empêche le condensateur de se décharger à travers l'interrupteur I1. Le condensateur C1 se décharge dans une résistance R1 aux bornes de laquelle est prélevée la tension d'alimentation U du circuit électronique 3.

Lorsque la tension aux bornes du condensateur C1 atteint une seconde valeur donnée de seuil V2, inférieure à V1, le détecteur de seuil DS1 commande l'ouverture de l'interrupteur I1 et le condensateur C1 se recharge. Le même cycle se répète tant que le courant délivré par le tore est supérieur au courant demandé par la charge.

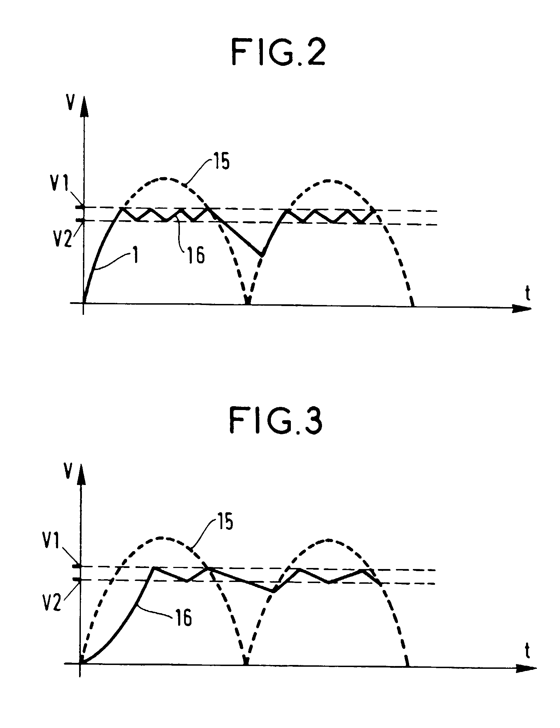

Si le condensateur est de faible capacité, un creux de tension apparaît périodiquement, comme le montre la figure 2. La courbe 15 représente la tension de sortie du pont redresseur 12 et la courbe 16 la tension aux bornes du condensateur C1. On constate que la courbe 16 présente un creux entre les créneaux de la courbe 15. Ce creux pourrait être réduit en utilisant un condensateur de plus grande capacité, comme le montre la figure 3, mais alors on retarde l'établissement de la tension aux bornes du condensateur.

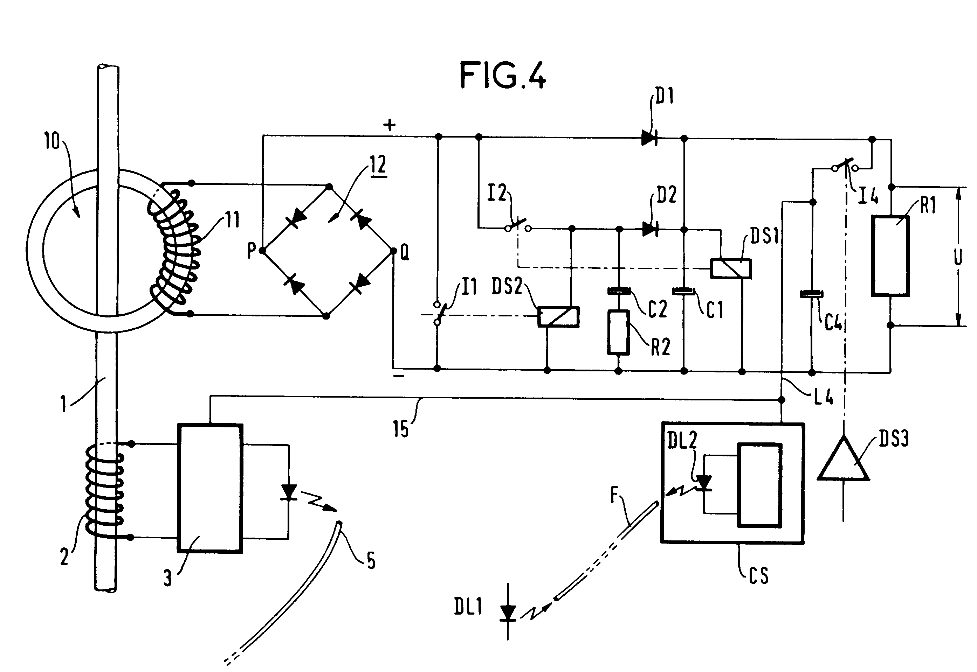

La figure 4 est un schéma d'un dispositif d'alimentation selon l'invention.

Les éléments communs aux figures 1 et 4 ont reçu les mêmes numéros de référence.

Le perfectionnement apporté au circuit consiste d'abord à connecter, entre les sorties P et Q du pont redresseur, c'est-à-dire entre les branches marquées + et - du circuit d'alimentation, une branche comprenant un second condensateur C2 en série avec un interrupteur électronique I2 et une résistance R2; une diode D2 relie les bornes positives des condensateurs C1 et C2. L'interrupteur I2 est commandé par un détecteur à seuil DS1 aux bornes du condensateur C1, et l'interrupteur I1 est commandé par un détecteur de seuil DS2 aux bornes du condensateur C2. Le fonctionnement est le suivant:

Au temps initial, le condensateur C1 se charge, les interrupteurs I1 et I2 étant ouverts. Lorsque la tension aux bornes du condensateur C1 atteint un seuil prédéterminé S1, détecté par le détecteur de seuil DS1, ce dernier commande la fermeture de l'interrupteur I2; le condensateur C2 se charge; lorsque la tension aux bornes de C2 atteint un seuil s2, inférieur ou égal au seuil s1 et détecté par le détecteur DS2, ce dernier commande la fermeture de l'interrupteur I1. Le transformateur de courant est alors court-circuité et le condensateur C1 se décharge dans la résistance R1 aux bornes de laquelle est prélevée la tension U d'alimentation du circuit 3. Tant que le courant donné par le transformateur de courant est supérieur au courant demandé par la charge, le cycle de charge et de décharge du condensateur C1 se poursuit entre C1 et I1.

Quand cette condition cesse d'être réalisée, il apparaît un creux de tension qui est comblé par la décharge du condensateur C2.

Le problème de l'apparition rapide de l'alimentation se pose lorsqu'on met sous tension une ligne affectée d'un défaut. Il faut alors sans retard (par exemple en moins d'une milliseconde), fournir l'information sur la valeur de l'intensité du courant (information "courant") aux protections qui sont chargées d'éliminer le défaut.

La première amélioration apportée par l'invention concerne le transformateur de courant.

On sait qu'un transformateur de courant délivre au secondaire un courant dont l'intensité est inversemment proportionnelle au nombre de spires de l'enroulement secondaire.

Si on réalise un transformateur de courant avec un petit nombre de spires secondaires, le courant délivré au secondaire sera élevé, ce qui est souhaitable à la mise sous tension de la ligne, mais il sera alors très difficile de réaliser une alimentation résistant aux surcharges, ou même supportant le courant permanent.

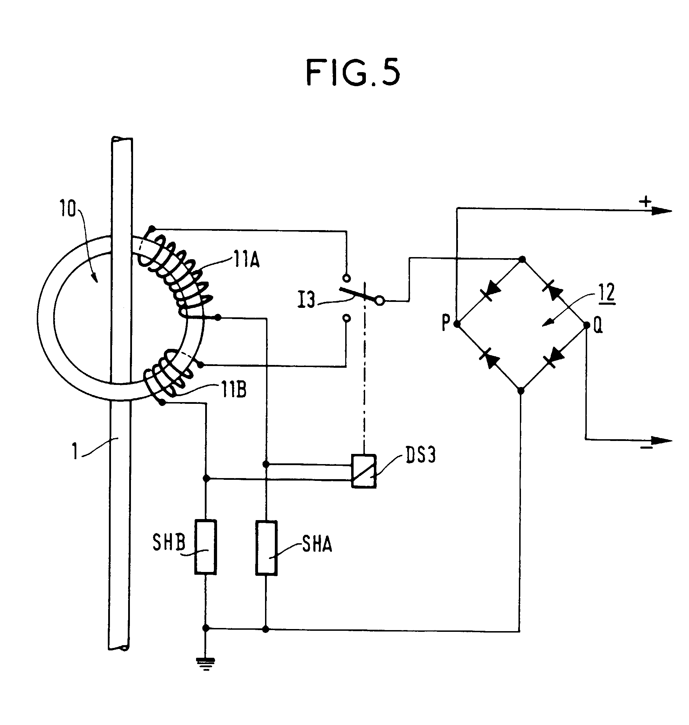

Le montage de la figure 5 illustre une une première solution apportée par le Demandeur à ce problème:

le secondaire du transformateur de courant comporte deux enroulements 11A et 11 B en série, avec un nombre inégal de spires; un interrupteur I3, en série avec les deux enroulements, permet de connecter au pont redresseur 12, celui des deux enroulements qui convient. La commande de l'interrupteur I3 est fournie, dans un premier mode de réalisation, par un détecteur de seuil qui surveille le courant circulant dans le secondaire. Ce détecteur, référencé DS3, reçoit les valeurs des courants dans chacun des enroulements, pondérées par des shunt SHA et SHB pour tenir compte du nombre de spires de chacun des enroulements 11A et 11B.

En variante, l'interrupteur I3 est commandé par le détecteur à seuil DS2 rencontré précédemment en référence à la figure 4.

Dans une autre variante de réalisation, l'alimentation est partiellement fournie par une fibre optique alimentée au sol par une diode laser ou par une diode électroluminescente, l'énergie lumineuse traversant la fibre étant convertie en énergie électrique par une photodiode, puis amenée à la tension désirée par un convertisseur électronique.

Une telle variante est illustrée dans la figure 4.

La fibre optique F est alimentée en énergie lumineuse par une diode DL1; au niveau de la ligne électrique un circuit convertisseur CS, comprenant une photodiode DL2, transforme la lumière en courant électrique. Le convertisseur peut être un simple transformateur suivi d'un redresseur, si la lumière est pulsée, par exemple à 10 kHz. Le courant électrique élaboré par le convertisseur CS est transmis à la branche + du circuit d'alimentation au moyen d'une liaison L4 en série avec un interrupteur commandé I4. Un condensateur C4 relie la liaison L4 à la branche - du circuit d'alimentation. L'interrupteur I4 est avantageusement piloté par le circuit de mesure du courant DS3 de la figure 5. Lorsque le courant devient trop petit, ce qui est détecté par le détecteur DS3, ce dernier commande la fermeture de l'interrupteur I4 et le condensateur C4 fournit le courant nécessaire.

La fibre optique peut être utilisée pour envoyer les ordres de synchronisation nécessaires aux conversion analogiques-numériques qui doivent être simultanées pour les mesures de courant et de tension des trois phases.

On peut par exemple utiliser la technique dite des "impulsions manquantes": sur la série des impulsions qui transitent dans la fibre F, on fait disparaître une impulsion, le début de la conversion correspondant par exemple au front montant de l'impulsion qui suit l'impulsion manquante. La ligne 15 désigne la liaison entre le convertisseur CS et le convertisseur 3 pour la transmisssion des informations précitées.

Lorsque la ligne 1 est reliée à un disjoncteur effectuant une opération d'ouverture suivie de fermeture (cycle OF), il en résulte une interruption du courant dans la ligne qui dure quelques dixièmes de seconde. Pour maintenir l'alimentation pendant cette période, on pourra utiliser un condensateur C2 de forte valeur (1000 µF par exemple), en série avec une résistance R2 limitant le courant à une valeur de 1mA par exemple. De la sorte, l'apparition de l'alimentation n'est pas retardée. Le temps de charge du condensateur C2 est long, mais cela est sans conséquence car le cycle OF est supposé arriver longtemps après la mise sous tension de la ligne.

## Revendications

1. Dispositif pour la fourniture d'une tension d'alimentation à un circuit électronique, en particulier à un circuit électronique (3) associé à un capteur de courant pour la mesure du courant électrique d'une ligne à haute tension, ledit dispositif comprenant un transformateur de courant ayant un circuit primaire (10) et un circuit secondaire (11), un pont redresseur (12) aux bornes du circuit secondaire, et aux bornes de sortie (P, Q) du pont redresseur, un premier condensateur (C1) en parallèle avec une première résistance (R1) aux bornes de laquelle est prélevée ladite tension d'alimentation (U), un premier interrupteur (I1) étant disposé entre les bornes de sortie (P, Q) du pont redresseur, caractérisé en ce qu'il comprend, entre les bornes de sortie (P,Q) du pont redresseur, une branche comprenant en série un second condensateur (C2), un second interrupteur (I2) et une seconde résistance (R2), le premier interrupteur (I1) étant commandé par un premier détecteur à seuil (DS2) aux bornes du second condensateur (C2), le second interrupteur (I2) étant commandé par un second détecteur à seuil (DS1) aux bornes du premier condensateur (C1), les premier (DS1) et second (DS2) détecteurs de seuil provoquant la fermeture respective des premier (I1) et second (I2) interrupteurs lorsque des premier (s1) et second (s2) seuils prédéterminés sont respectivement atteints.

2. Dispositif selon la revendication 1, caractérisé en ce que le transformateur de courant comprend deux enroulements secondaires (11A, 11B) ayant des nombres respectifs de spires différents et reliés en serie au pont redresseur (12) à travers un troisième interrupteur (I3) commandé.

3. Dispositif selon la revendication 2, caractérisé en ce que le troisième interrupteur (I3) est commandé par un troisième détecteur (DS3) recevant les courants traversés par les enroulements secondaires (11A, 11B).

4. Dispositif selon la revendication 2, caractérisé en ce que le troisième interrupteur (I3) est commandé par ledit premier détecteur à seuil (DS2).

5. Dispositif selon l'une des revendications 1 à 4, caractérisé en ce qu'il comprend, aux bornes de sortie du pont redresseur, une branche comprenant un troisième condensateur (C4) en série avec un quatrième interrupteur (I4), ledit condensateur étant relié à une ligne d'alimentation (L4) recevant l'énergie électrique fournie à la sortie d'un convertisseur opto-électronique (CS) recevant en entrée de l'énergie lumineuse acheminée depuis le sol par une fibre optique F, ledit quatrième interrupteur (I4) étant commandé par ledit troisième détecteur (DS3).

6. Dispositif selon la revendication 5, caractérisé en ce que l'énergie lumineuse dans la fibre optique (F) est envoyée sous forme d'impulsions utilisées en outre pour élaborer des ordres de synchronisation adressés audit circuit électronique (3).

## Patentansprüche

1. Vorrichtung zum Aufbau einer Speisespannung für eine elektronische Schaltung, insbesondere für eine einer Strommeßsonde für die Messung des Stroms einer Hochspannungsleitung zugeordneten elektronischen Schaltung (3), wobei die Vorrichtung einen Stromtransformator (10) mit einer Primärwicklung und einer Sekundärwicklung (11), eine Gleichrichterbrücke (12) an den Klemmen der Sekundärwicklung, wobei an die Ausgangsklemmen (P, Q) der Gleichrichterbrücke ein erster Kondensator (C1) in Parallelschaltung mit einem ersten Widerstand (R1) angeschlossen ist, an dessen Klemmen die Speisespannung (U) abgenommen wird, und wobei ein erster Schalter (I1) zwischen den Ausgangsklemmen (P, Q) der Gleichrichterbrücke angeordnet ist, dadurch gekennzeichnet, daß sie zwischen den Ausgangsklemmen (P, Q) der Gleichrichterbrücke einen Zweig aufweist, der in Serie einen zweiten Kondensator (C2), einen zweiten Schalter (I2) und einen zweiten Widerstand (R2) besitzt, daß der erste Schalter (I1) von einem ersten Schwellendetektor (DS2) an den Klemmen des zweiten Kondensators (C2) gesteuert wird, daß der zweite Schalter (I2) von einem zweiten Schwellendetektor (DS1) an den Klemmen des ersten Kondensators (C1) gesteuert wird, und daß der erste (DS2) und der zweite Schwellendetektor (DS1) das Schließen des ersten (I1) bzw. des zweiten Schalters (I2) bewirken, wenn die erste (sl) bzw. die zweite vorbestimmte Schwelle (s2) erreicht ist.

2. Vorrichtung nach Anspruch 1, dadurch gekennzeichnet, daß der Stromtransformator zwei Sekundärwicklungen (11A, 11B) aufweist, die unterschiedliche Anzahlen von Windungen aufweisen und die je über einen dritten gesteuerten Schalter (I3) in Reihe mit der Gleichrichterbrücke (12) verbunden sind.

3. Vorrichtung nach Anspruch 2, dadurch gekennzeichnet, daß der dritte Schalter (I3) von einem dritten Schwellendetektor (DS3) gesteuert wird, der die durch die Sekundärwicklungen (11A, 11B) fließenden Ströme empfängt.

4. Vorrichtung nach Anspruch 2, dadurch gekennzeichnet, daß der dritte Schalter (I3) vom ersten Schwellendetektor (DS2) gesteuert wird.

5. Vorrichtung nach einem der Ansprüche 1 bis 4, dadurch gekennzeichnet, daß sie an den Ausgangsklemmen der Gleichrichterbrücke einen Zweig besitzt, der einen dritten Kondensator (C4) in Serie mit einem vierten Schalter (I4) aufweist, wobei der Kondensator mit einer Speiseleitung (L4) verbunden ist, die die am Ausgang eines optoelektronischen Wandlers (CS) gelieferte elektrische Energie empfängt, der am Eingang Lichtenergie empfängt, die über eine Lichtleitfaser F vom Boden kommt, wobei der vierte Schalter (I4) vom dritten Detektor (DS3) gesteuert wird.

6. Vorrichtung nach Anspruch 5, dadurch gekennzeichnet, daß die Lichtenergie in der Lichtleitfaser (F) in Form von Impulsen gesendet wird, die außerdem verwendet werden, um an die elektronische Schaltung (3) gerichtete Synchronisationsbefehle zu übermitteln.

## Claims

1. Device for supplying a power supply voltage to an electronic circuit, in particular to an electronic circuit (3) associated with a current sensor for measuring the electrical current in a high-tension line, said device comprising a current transformer having a primary circuit (10) and a secondary circuit (11), a rectifier bridge (12) shunting the secondary circuit and output terminals (P, Q) of the rectifier bridge, a first capacitor (C1) in parallel with a first resistor (R1) across which said power supply voltage (U) is obtained, a first switch (I1) being disposed between the output terminals (P, Q) of the rectifier bridge, characterised in that it comprises between the output terminals (P, Q) of the rectifier bridge a branch comprising in series a second capacitor (C2), a second switch (I2) and a second resistor (R2), the first switch (I1) being controlled by a first threshold detector (DS2) shunting the second capacitor (C2), the second switch (I2) being controlled by a second threshold detector (DS1) shunting the first capacitor (C1), the first and second threshold detectors (DS1, DS2) respectively closing the first and second switches (I1, I2) when predetermined first and second thresholds (sl, s2) are respectively reached.

2. Device according to claim 1 characterised in that the current transformer comprises two secondary windings (11A, 11B) having different numbers of turns and connected in series to the rectifier bridge connected to the rectifier bridge (12) through a controlled third switch (I3).

3. Device according to claim 2 characterised in that the third switch (I3) is controlled by a third sensor (DS3) receiving the current flowing through the secondary winding (11A, 11B).

4. Device according to claim 2 characterised in that the third switch (I3) is controlled by said first threshold detector (DS2).

5. Device according to any one of claims 1 to 4 characterised in that it comprises, shunting the rectifier bridge output, a branch including in series a third capacitor (C4) in series with a fourth switch (I4), said capacitor being connected to a power supply line (L4) receiving electrical energy from the output of an opto-electronic converter (CS) receiving at its input luminous energy conveyed from the ground by an optical fibre F, said fourth switch (I4) being controlled by said third detector (DS3).

6. Device according to claim 5 characterised in that the luminous energy in the optical fibre (F) is sent in the form of pulses also used to generate synchronisation instructions sent to said electronic circuit (3).
